# EUROPÄISCHE PATENTSCHRIFT

(11) **EP 3 455 915 B1**
(45) Veröffentlichungstag und Bekanntmachung des Hinweises auf die Patenterteilung: **04.05.2022**
(21) Anmeldenummer: 17736922.0
(22) Anmeldetag: 04.07.2017
(51) Int. Cl.: H02J 3/14, B60M 3/00

(54) **VERFAHREN UND EINRICHTUNG ZUR ÜBERWACHUNG EINER ENERGIEVERSORGUNGSEINRICHTUNG EINER VERKEHRSTECHNISCHEN ANLAGE**
METHOD AND DEVICE FOR MONITORING A POWER SUPPLY DEVICE OF A TRAFFIC SYSTEM
PROCÉDÉ ET DISPOSITIF DE SURVEILLANCE D'UN DISPOSITIF D'ALIMENTATION ÉLECTRIQUE D'UNE INSTALLATION TECHNIQUE DE TRANSPORT

(30) Priorität: 08.07.2016 DE 102016212494
(43) Veröffentlichungstag der Anmeldung: 20.03.2019
(73) Patentinhaber: Siemens Mobility GmbH, 81739 München (DE)
(72) Erfinder: SCHMID, Otto, 91341 Röttenbach (DE); ALTMANN, Martin, 91054 Erlangen (DE); POMEISL, Imre, 91096 Möhrendorf (DE)
(86) Internationale Anmeldenummer: PCT/EP2017/066554
(87) Internationale Veröffentlichungsnummer: WO 2018/007345

(56) Entgegenhaltungen:
- JP-B2- 3 350 084
- KR-A- 20130 129 593
- US-A1- 2011 144 831

## Beschreibung

Die Erfindung betrifft ein Verfahren zur Überwachung einer Energieversorgungseinrichtung einer verkehrstechnischen Anlage, bei dem ein computerbasiertes Modell der Energieversorgungseinrichtung unter anderem mit Hilfe von vorbestimmten für die Energieversorgungseinrichtung relevanten Parametern erstellt wird.

Ferner betrifft die Erfindung eine Einrichtung zur Überwachung einer Energieversorgungseinrichtung einer verkehrstechnischen Anlage mit wenigstens einer Modelleinrichtung, die aus vorbestimmten für die Energieversorgungseinrichtung relevanten Parametern ein computerbasiertes Modell der Energieversorgungseinrichtung erstellt.

Aus der US_2011/144831_A1 ist ein "power supply control system" sowie eine "power supply control method" bekannt. Aus der KR 2013 0129593 A ist ein "peak power distributed control system for an urban railway based on individual power metering of a rolling stock" bekannt. Des Weiteren ist aus der JP 3 350084 B2 ein "electric railway power load predicting device" bekannt.

Verfahren und Einrichtung der oben genannten Art ist aus dem Stand der Technik beispielsweise durch die Simulationssoftware Sitras Sidytrac von der Firma Siemens bekannt, mit deren Hilfe eine AC- oder DC-Bahnstromversorgung simuliert werden kann. Hierbei werden vorbestimmte Parameter, die für die Energieversorgungseinrichtung relevant sind, eingegeben und anschließend erstellt die Software ein computerbasiertes Modell der Energieversorgungseinrichtung. An dem Modell können Informationen abgelesen werden, die beispielsweise für die Auslegung der Energieversorgungseinrichtung relevant sind.

Durch das bekannte Verfahren und die Software kann eine Energieversorgungseinrichtung in der Auslegungsphase besser geplant werden, um eine ausreichende und optimale Auslegung zu garantieren.

Die aus dem Stand der Technik bekannte Planungssoftware modelliert den Fahrbetrieb mit der Stromversorgung so, dass es für die zu diesem Zeitpunkt spezifizierten Einsatzpunkte ausgelegt ist. Die Simulation kann mehrere Stunden dauern und bildet häufig die Basis für die Auslegung der Energieversorgungseinrichtung.

Eine Energieversorgungseinrichtung kann unter anderem beispielsweise eine Einspeisung von einem übergeordneten Netz, AC-Schaltanlagen für Hochspannung, Mittelspannung und Niederspannung, DC-Schaltanlagen, Transformatoren, Gleichrichter, Wechselrichter, Umrichter, Schutzgeräte und Stationsleittechnik, erneuerbare Energien, Speicher, Kabel, Fahrleitungskomponenten und andere Leitungskomponenten zur Führung des Stromes beinhalten.

Allerdings sind heutige Energieversorgungseinrichtungen schwerer vorhersagbar als früher, da beispielsweise nicht alle Parameter für die Auslegung bekannt sind, die Energieversorgung teilweise nicht ausreichend groß ist, Fahrpläne sich häufig ändern bzw. deren Pünktlichkeit nicht immer gegeben ist. Ferner machen der heutige Einsatz von dezentralen Energiequellen, wie beispielsweise Windkraft oder Solaranlagen, Energiespeichern oder einem Lastmanagement im Zuge eines Energiemanagements die Bahnnetze dynamischer und schwerer vorhersagbar.

Es ist daher die Aufgabe der vorliegenden Erfindung, Verfahren und Einrichtung der eingangs genannten Art bereitzustellen, die den veränderten Anforderungen an eine Energieversorgungseinrichtung einer verkehrstechnischen Anlage Rechnung tragen.

Die Aufgabe wird für das eingangs genannte Verfahren durch die Merkmale des unabhängigen Patentanspruchs 1 gelöst. Erfindungsgemäß wird wenigstens eine aktuelle Kenngröße im laufenden Betrieb der verkehrstechnischen Anlage ermittelt und der Betrieb der Energieversorgungseinrichtung wenigstens mit Hilfe des Modells und der Kenngröße simuliert.

Gelöst wird die Aufgabe weiterhin für die eingangs genannte Einrichtung durch die Merkmale des unabhängigen Patentanspruchs 4. Erfindungsgemäß weist die Einrichtung wenigstens eine Erfassungseinrichtung, die zum Ermitteln von wenigstens einer aktuellen Kenngröße der verkehrstechnischen Anlage im laufenden Betrieb ausgebildet ist, und wenigstens eine Simulationseinrichtung, die zum Simulieren der Energieversorgungseinrichtung mit Hilfe des Modells und der wenigstens einen Kenngröße ausgebildet ist, auf.

Die erfindungsgemäße Lösung hat den Vorteil, dass die Energieversorgungseinrichtung während ihres Betriebs simuliert wird und nicht nur in der Planungsphase. Dadurch wird die Simulation auf einem aktuellen Stand gehalten, an dem der aktuelle Zustand der Energieversorgungseinrichtung leicht abgelesen werden kann. Durch die erfindungsgemäße Simulation der Energieversorgungseinrichtung können situationsgerecht während des realen Betriebs laufende Betriebsparameter der Energieversorgungseinrichtung berechnet und überwacht werden.

Weiterhin kann durch die erfindungsgemäße Simulation ein zukünftiges Verhalten der Energieversorgungseinrichtung bestimmt werden. Daraus können entsprechende Maßnahmen abgeleitet werden, die auch automatisch eingeleitet werden können.

Durch die erfindungsgemäße Lösung können beispielsweise Energiebedarf und Energieverbrauch, Lastflüsse und Belastungsgrenzen von Systemen und Komponenten der Energieversorgungseinrichtung der verkehrstechnischen Anlage, Betriebsgrenzen, Sinnhaftigkeit des Einsatzes von Speicherlösungen und Rückspeisesysteme, sowie deren Einsatzparameter berechnet werden.

Die Ergebnisse können im Zuge von beispielsweise Scada- und Energiemanagementsystemen, inklusive Lastmanagement, eingesetzt werden, um diese zu verbessern. Die mit Hilfe der Erfindung aktuell berechneten Werte erlauben höhere Reaktionsgeschwindigkeiten zur Betriebsbeeinflussung bzw. Betriebsoptimierung. Bei Scadasystemen können beispielsweise sogenannte Was-Wäre-Wenn-Abfragen (What if-Abfragen) vor entsprechenden Schalthandlungen sowie automatische Betriebsempfehlungen, Berechnungen und Alarmierungen bei ungünstigen Betriebspunkten - besonders bei schwachen Streckenabschnitten bzw. bei Sonderfahrplänen - unterstützt werden.

Für Energiemanagementsysteme ergeben sich durch die Erfindung neue Möglichkeiten bei Lastflussvorhersagen und ein optimierter Betrieb der Stromversorgung. Ferner können automatische Meldungen an Triebfahrzeugführer durch Fahrerassistenzsysteme (Driver Advisery Systems) herausgegeben werden. Ferner kann eine automatische Beeinflussung bei Erreichen von Grenzen der Stromversorgung bzw. zur Optimierung der Fahrweisen nach einem energetischen Optimum, beispielsweise zur Vermeidung von Lastspitzen, umgesetzt werden. Durch die Erfindung kann ein systembasiertes Know-How für Schutz und Einstellungen aufgebaut werden, anstatt einem personenbasierten Know-How, das bei hoher Mitarbeiterfluktuation oder einem Generationswechsel beispielsweise problematisch sein kann.

Erfindungsgemäß wird wenigstens ein zukünftiger Kennwert mit Hilfe der Simulation zumindest in einem gewünschten Zukunftszeitraum vorausberechnet und der Kennwert mit wenigstens einem vorgegebenen Grenzwert verglichen. Dies hat den Vorteil, dass eine drohende Überschreitung von Grenzwerten frühzeitig erkannt werden kann und entsprechende Gegenmaßnahmen ergriffen werden können.

Um auf eine drohende Überschreitung der Grenzwerte noch besser hinzuweisen oder aktiv zu reagieren, wird erfindungsgemäß bei Erreichen und/oder Überschreiten der Grenzwerte wenigstens eine Warnmeldung automatisch ausgegeben oder wenigstens eine Maßnahme automatisch eingeleitet. Die Warnmeldung kann beispielsweise an eine Leitstelle der verkehrstechnischen Anlage oder der Energieversorgungseinrichtung übermittelt werden.

Ferner wird erfindungsgemäß wenigstens ein simulierter Kennwert mit Hilfe der Simulation berechnet und der simulierte Kennwert mit einem im laufenden Betrieb der verkehrstechnischen Anlage ermittelten Kennwert verglichen.

Simulierte und zukünftige Kennwerte sind beispielsweise elektrische Kennwerte wie Strom, Spannung und daraus ableitbare Größen wie Impedanzen Widerstände, Leistung oder Energie.

Weiterhin werden erfindungsgemäß mit Hilfe der Simulation Vorgaben für den zukünftigen Betrieb der verkehrstechnischen Anlage berechnet. Dies hat den Vorteil, dass eine bessere Betriebsplanung der verkehrstechnischen Anlage möglich ist.

Die erfindungsgemäße Lösung kann durch vorteilhafte Ausgestaltungen weiterentwickelt werden, die im Folgenden beschrieben sind.

In einer vorteilhaften Ausgestaltung der Erfindung können die aktuellen Kenngrößen und/oder die Kennwerte in Echtzeit ermittelt werden. Dies hat den Vorteil, dass das erfindungsgemäße Verfahren besonders schnell arbeitet und dadurch Maßnahmen schnell und kurzfristig ergriffen werden können. So ist das Verfahren besonders geeignet für die heutigen dynamischen Energienetze.

Die Erfindung betrifft schließlich auch eine eisenbahntechnische Anlage, die eine erfindungsgemäße Einrichtung nach der oben genannten Ausführungsform umfasst.

Eine verkehrstechnische Anlage kann beispielsweise eine eisenbahntechnische Anlage mit spurgebundenen Fahrzeugen oder auch eine Anlage mit E-Trucks - also Lastwagen mit einer elektrischen Energieversorgung - sein.

Im Folgenden wird die Erfindung mit Bezug auf die beigefügten Zeichnungen erläutert.

Es zeigen:
- Figur 1: eine schematische Darstellung einer beispielhaften Ausführungsform einer erfindungsgemäßen Einrichtung zur Überwachung einer Energieversorgungseinrichtung einer verkehrstechnischen Anlage;
- Figur 2: eine schematische Darstellung einer beispielhaften Ausführungsform einer erfindungsgemäßen verkehrstechnischen Anlage.

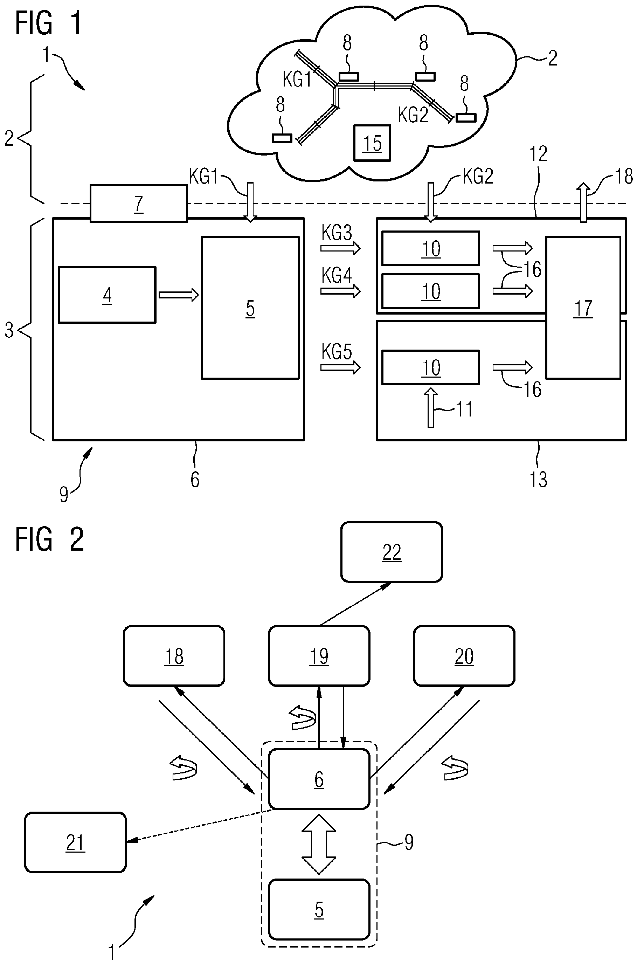

Die in Figur 1 beispielhaft dargestellte verkehrstechnische Anlage ist eine eisenbahntechnische Anlage 1, die hier beispielhaft einen real existierenden Teil 2 und einen digital existierenden Teil 3 aufweist.

Im realen Teil 2 befindet sich beispielsweise das Streckennetz, die Schienenfahrzeuge, die Energieversorgungseinrichtung 15, die Signaltechnik, die Bahnhöfe etc. Die Energieversorgungseinrichtung 15 stellt die nötige Energie für die eisenbahntechnische Anlage 1 zur Verfügung und ist z. B. eine Traktionsenergieversorgung.

Der digitale Teil 3 umfasst bei der Ausführung in Figur 1 mehrere Funktionseinrichtungen 10, eine Recheneinrichtung 17 und eine Simulationseinrichtung 6, die eine Parametereinrichtung 4 und eine Modelleinrichtung 5 aufweist.

Eine Kommunikationseinrichtung 7 verbindet den realen Teil 2 mit dem digitalen Teil 3. Im realen Teil 2 der eisenbahntechnischen Anlage 1 sind weiterhin mehrere Erfassungseinrichtungen 8 vorhanden, die Kenngrößen KG1 und Kennwerte KG2 der eisenbahntechnischen Anlage 1 über die Kommunikationseinrichtung 7 an den digitalen Teil 3 übermitteln.

Die verkehrstechnische Anlage 1 weist eine erfindungsgemäße Überwachungseinrichtung 9 auf, die die Erfassungseinrichtungen 8, die Kommunikationseinrichtung 7 und die Simulationseinrichtung 6 mit der Modelleinrichtung 5 und der Parametereinrichtung 4 umfasst.

Die Erfassungseinrichtungen 8 können verschiedenste Arten von Sensoren oder Einrichtungen sein, die Kenngrößen KG1 und/oder Kennwerte KG2 des realen Teils 2 der eisenbahntechnischen Anlage 1 erfassen und/oder liefern. Die Kenngrößen KG1 können beispielsweise ein aktueller Fahrplan, aktuelle Daten der Schienenfahrzeuge, GPS-Positionen und ähnliches sein. Die Kennwerte KG2 sind beispielsweise elektrische Kennwerte wie Strom, Spannung und daraus ableitbare Größen wie Impedanzen Widerstände, Leistung oder Energie. Die Kenngrößen KG1 und Kennwerte KG2 werden im Betrieb über die Kommunikationseinrichtung 7 an den digitalen Teil 3 übermittelt.

Die Parametereinrichtung 4 weist vorbestimmte für die Energieversorgungseinrichtung 15 relevante Parameter auf, wie beispielsweise eine Topografie oder Limits der Netzwerkkomponenten, Sollfahrpläne oder ein erwartetes Verhalten von Lasten und Netzwerkkomponenten. Die Parameter sind in der Parametereinrichtung beispielsweise gespeichert.

Die Modelleinrichtung 5 ist zum Erstellen eines Modells der Energieversorgungseinrichtung 15 ausgebildet und ist mit der Parametereinrichtung 4 verbunden. Die Modelleinrichtung 5 verwendet zur Erstellung des Modells die in der Parametereinrichtung 4 vorhandenen Parameter und ggf. auch Kenngrößen KG1. Das von der Modelleinrichtung 5 erstellte Modell der Energieversorgungseinrichtung wird von der Simulationseinrichtung 6 zur Simulation der Energieversorgungseinrichtung 15 verwendet. Die Modelleinrichtung 5 und die Parametereinrichtung 4 müssen nicht als separate Einheiten ausgebildet sein.

Die Simulationseinrichtung 6 erhält die ermittelten Kenngrößen KG1 als Ist-Werte der eisenbahntechnischen Anlage 1 über die Kommunikationseinrichtung 7 in Echtzeit oder quasi in Echtzeit. Die Kenngrößen KG1 sind im Gegensatz zu den Kennwerten KG2 dabei solche, die zur Simulation der Energieversorgungseinrichtung 15 verwendet werden, wie beispielsweise ein aktueller Fahrplan, aktuelle Daten der Schienenfahrzeuge oder GPS-Positionen oder auch aktuelle Schaltzustände. Die Simulationseinrichtung 6 simuliert mit dem von der Modelleinrichtung 5 erstellten Simulations-Modell und den Kenngrößen KG1 die Energieversorgungseinrichtung 15.

Die Überwachungseinrichtung 9 umfasst mehrere der Funktionseinrichtungen 10, die in der Simulationseinrichtung 6 berechnete Kennwerte KG3, KG4, KG5 mit vorbestimmten Grenzwerten 11 und/oder den aktuellen Kennwerten KG2 vergleichen. Die aktuellen Kennwerte KG2 sind beispielsweise elektrische Kennwerte wie Strom, Spannung und daraus ableitbare Größen wie Impedanzen Widerstände, Leistung oder Energie. Die aktuellen Kennwerte KG2 sind die aktuellen Vergleichswerte zu den simulierten Kennwerten KG3, KG4, um einen Vergleich zwischen den in der Simulation berechneten Kennwerten KG3, KG4 zu den real existierenden Kennwerten KG2 ziehen zu können. Die berechneten Kennwerte KG3, KG4, KG5 können auch ein zeitlicher Verlauf von Werten beispielsweise in Form einer Kurve sein. Dabei kann zwischen einem aktuellen Bereich 12 und einen Vorschaubereich 13 unterschieden werden.

Im aktuellen Bereich 12 werden die in der Simulationseinrichtung 6 berechneten Kennwerte KG3, KG4 mit den aktuellen Kennwerten KG2 verglichen.

Im Vorschaubereich 13 werden vorausberechnete zukünftige Kennwerte KG5 mit den Grenzwerten 11 verglichen und dadurch eine Prognose für den zukünftigen Betrieb der Energieversorgungseinrichtung 15 gegeben.

Die Funktionseinrichtungen 10 geben ihre Vergleichsergebnisse 16 an eine Recheneinrichtung 17 weiter, die bei Überschreiten der Grenzwerte 11 eine Warnmeldung 18 in den realen Teil 2 übermittelt, beispielsweise an eine Leitstelle der eisenbahntechnischen Anlage 1. Alternativ oder zusätzlich zu den Warnmeldungen 18 können auch automatische Maßnahmen eingeleitet werden. So kann beispielsweise das Fahrverhalten der Züge über eine Automatische Zugsteuerung beeinflusst werden.

Die Funktionseinrichtungen 10 und/oder die Recheneinrichtung 17 können auch von der Simulationseinrichtung 6 oder externen Systemen, wie sie beispielsweise in Figur 2 gezeigt sind, ausgebildet werden.

Figur 2 zeigt eine schematische Darstellung einer eisenbahntechnischen Anlage 1 und eines möglichen Austauschs der erfindungsgemäßen Überwachungseinrichtung 9 mit anderen Einrichtungen der eisenbahntechnischen Anlage 1. Dabei steht die erfindungsgemäße Überwachungseinrichtung 9 in Kontakt mit einem Fahrplanmanagementsystem 18, einem Lastmanagementsystem 19, einem Scada-System 20 und gegebenenfalls einer Analyseeinrichtung 21. An das Lastmanagement 19 ist beispielsweise eine echtzeitfähige Steuerung 22 angebunden. Mit dem Fahrplanmanagementsystem 18, dem Lastmanagementsystem 19 und dem Scada-System 20 kommuniziert die erfindungsgemäße Überwachungseinrichtung 9 in beide Richtungen. Die Kommunikation kann beispielsweise mit einer Zykluszeit im Sekundentakt, beispielsweise von etwa 3 s, oder auch schneller geschehen.

Das Scada-System 20 kann beispielsweise eine Entscheidungsunterstützungsfunktion aufweisen, die einem Bediener die Prüfung von Testszenarien ermöglicht ("Was-wäre wenn"). Hierbei kann der Bediener eine mögliche Veränderung der eisenbahntechnischen Anlage 1 in das Scada-System 20 eingeben, das mit Hilfe der erfindungsgemäßen Überwachungseinrichtung 9 dem Bediener eine Rückmeldung bezüglich des Tests gibt.

## Patentansprüche

1. Verfahren zur Überwachung einer Energieversorgungseinrichtung (15) einer verkehrstechnischen Anlage (1),
bei dem ein computerbasiertes Modell der Energieversorgungseinrichtung (15) unter anderem mit Hilfe von vorbestimmten für die Energieversorgungseinrichtung (15) relevanten Parametern erstellt wird,
**dadurch gekennzeichnet, dass**
- wenigstens eine aktuelle Kenngröße (KG1), die zur Simulation der Energieversorgungeinrichtung (15) verwendet wird, mit einer Erfassungseinrichtung (8) ermittelt wird, und wenigstens ein aktueller Kennwert (KG2), der als aktueller Vergleichswert zu wenigstens einem, in der Simulation berechneten Kennwert (KG3, KG4) verwendet wird, im laufenden Betrieb der verkehrstechnischen Anlage (1) mit einer Erfassungseinrichtung (8) ermittelt wird,wobei die Kenngrößen beispielsweise ein aktueller Fahrplan, aktuelle Daten der Schienenfahrzeuge oder GPS-Positionen oder auch aktuelle Schaltzustände sind, und
wobei die Kennwerte beispielsweise elektrische Kennwerte wie Strom, Spannung und daraus ableitbare Größen sind,
- so, dass der Betrieb der Energieversorgungseinrichtung (15) wenigstens mit Hilfe des Modells und der wenigstens einen Kenngröße (KG1) simuliert wird,
- und daraus folgend der wenigstens eine berechnete Kennwert (KG3, KG4) mit dem wenigstens einen aktuell ermittelten Kennwert (KG2) in einem aktuellen Bereich (12) verglichen wird,
- und weiterhin daraus folgend wenigstens ein zukünftiger Kennwert (KG5) mit Hilfe der Simulation zumindest in einem gewünschten Zukunftszeitraum vorausberechnet wird, und der wenigstens eine vorausberechnete zukünftige Kennwert (KG5) mit wenigstens einem vorgegebenen Grenzwert (11) in einem Vorschaubereich (13) verglichen wird und
- auf Basis der Vergleichsergebnisse in dem aktuellen Bereich (12) und dem Vorschaubereich (13) mit Hilfe der Simulation Vorgaben für den zukünftigen Betrieb der verkehrstechnischen Anlage (1) berechnet werden und bei Erreichen und/oder Überschreiten des wenigstens einen Grenzwerts (11) wenigstens eine Warnmeldung (18) automatisch ausgegeben wird und/oder wenigstens eine Maßnahme, beispielsweise das Fahrverhalten der Züge über eine automatische Zugsteuerung beeinflussend, automatisch eingeleitet wird.

2. Verfahren nach Anspruch 1,
**dadurch gekennzeichnet, dass** der wenigstens eine aktuelle Kennwert (KG2) in Echtzeit ermittelt wird.

3. Verfahren nach Anspruch 1 oder 2,
**dadurch gekennzeichnet, dass** die wenigstens eine aktuelle Kenngröße (KG1) in Echtzeit ermittelt wird.

4. Einrichtung (9) zur Überwachung einer Energieversorgungseinrichtung (15) einer verkehrstechnischen Anlage (1), mit wenigstens einer Modelleinrichtung (5), die dazu ausgebildet ist, aus vorbestimmten für die Energieversorgungseinrichtung (15) relevanten Parametern ein computerbasiertes Modell der Energieversorgungseinrichtung (15) zu erstellen, **gekennzeichnet durch**,
- wenigstens eine Erfassungseinrichtung (8), die zum Ermitteln von wenigstens einer aktuellen Kenngröße (KG1) und wenigstens eines aktuellen Kennwerts (KG2) der verkehrstechnischen Anlage (1) im laufenden Betrieb ausgebildet ist,
- wenigstens eine Simulationseinrichtung (6), die zum Simulieren der Energieversorgungseinrichtung (15) mit Hilfe des Modells und der wenigstens einen Kenngröße (KG1), zur Berechnung wenigstens eines Kennwerts (KG3, KG4) und zur Vorausberechnung wenigstens eines zukünftigen Kennwerts (KG5) zumindest in einem gewünschten Zukunftszeitraum ausgebildet ist,
- einen aktuellen Bereich (12), in dem der wenigstens eine berechnete Kennwert (KG3, KG4) mit dem wenigstens einen aktuell ermittelten Kennwert (KG2) verglichen wird und
- einen Vorschaubereich (13), in dem der wenigstens eine vorausberechnete zukünftige Kennwert (KG5) mit wenigstens einem vorgegebenen Grenzwert (11) verglichen wird, und
- eine Recheneinheit (17), die dazu ausgebildet ist auf Basis der Vergleichsergebnisse mit Hilfe der Simulation Vorgaben für den zukünftigen Betrieb der verkehrstechnischen Anlage (1) zu berechnen und bei Erreichen und/oder Überschreiten des wenigstens einen Grenzwerts (11) wenigstens eine Warnmeldung (18) automatisch auszugeben und/oder wenigstens eine Maßnahme automatisch einzuleiten.

5. Verkehrstechnische Anlage (1),
**dadurch gekennzeichnet, dass** die Anlage eine Einrichtung (9) nach Anspruch 4 umfasst.

## Claims

1. Method for monitoring a power supply device (15) of a traffic system (1), in which a computer-based model of the power supply device (15) is inter alia created with the aid of predetermined parameters relevant to the power supply device (15),
**characterised in that**
at least one current characteristic quantity (KG1), which is used to simulate the power supply device (15), is determined with a detection device (8), and at least one current characteristic value (KG2), which is used as a current comparison value relating to at least one characteristic value (KG3, KG4) calculated in the simulation, is determined with a detection device (8) during ongoing operation of the traffic system (1), wherein the characteristic quantities are for instance a current timetable, current data of the rail vehicles or GPS positions or also current switching states, and
wherein the characteristic values are for instance electrical characteristic values such as power, voltage and variables which can be derived therefrom,
so that the operation of the power supply device (15) is simulated at least with the aid of the model and the at least one characteristic quantity (KG1),
- and consequentially the at least one calculated characteristic value (KG3, KG4) is compared with the at least one currently determined characteristic value (KG2) in a current region (12),
- and further consequentially at least one future characteristic value (KG5) is precalculated with the aid of the simulation at least in a desired future time period, and the at least one precalculated future characteristic value (KG5) is compared with at least one predetermined limit value (11) in a preview area (13) and
- on the basis of the comparison results in the current region (12) and the preview area (13) with the aid of the simulation, stipulations for the future operation of the traffic system (1) are calculated and when the at least one limit value (11) is reached and/or exceeded, at least one warning message (18) is automatically output and/or at least one measure, for instance the driving behaviour of the trains, is automatically introduced in an influential manner by way of an automatic train control.

2. Method according to claim 1,
**characterised in that**
the at least one current characteristic value (KG2) is determined in real time.

3. Method according to claim 1 or 2,
**characterised in that**
the at least one current characteristic quantity (KG1) is determined in real time.

4. Device (9) for monitoring a power supply device (15) of a traffic system (1), having at least one model device (5), which is embodied to create a computer-based model of the power supply device (15) from predetermined parameters which are relevant to the power supply device (15),
**characterised by**
- at least one detection device (8), which is embodied to determine at least one current characteristic quantity (KG1) and at least one current characteristic value ( KG2) of the traffic system (1) during ongoing operation,
- at least one simulation device (6), which is formed in order to simulate the power supply device (15) with the aid of the model and the at least one characteristic quantity (KG1), for calculating at least one characteristic value (KG3, KG4) and for precalculating at least one future characteristic value (KG5) at least in a desired future period of time,
- a current region (12), in which the at least one calculated characteristic value (KG3, KG4) is compared with the at least one currently determined characteristic value (KG2) and
- a preview area (13), in which the at least one precalculated future characteristic value (KG5) is compared with at least one precalculated limit value (11), and
- a computing unit (17), which is embodied to calculate stipulations for the future operation of the traffic system (1) on the basis of the comparison results with the aid of the simulation and when the at least one limit (11) is reached and/or exceeded, to output at least one warning message (18) automatically and/or to introduce at least one measure automatically.

5. Traffic system (1),
**characterised in that**
the system comprises a device (9) according to claim 4.

## Revendications

1. Procédé de contrôle d'un dispositif (15) d'alimentation en électricité d'une installation (1) de la technique des transports, dans lequel on établit un modèle reposant sur l'informatique du dispositif (15) d'alimentation en électricité, entre autres à l'aide de paramètres pertinents déterminés à l'avance pour le dispositif (15) d'alimentation en électricité,
**caractérisé en ce que**
- on détermine, par un dispositif (8) de relevé, une grandeur (KG1) caractéristique en cours, que l'on utilise pour la simulation du dispositif (15) d'alimentation en électricité et on détermine, par un dispositif (8) de relevé en fonctionnement en continu de l'installation (1) de la technique des transports, au moins une valeur (KG2) caractéristique en cours, que l'on utilise comme valeur de comparaison en cours à au moins une valeur (KG3, KG4) caractéristique calculée dans la simulation, dans lequel les grandeurs caractéristiques sont, par exemple, un plan de circulation en cours, des données en cours des véhicules ferroviaires ou des positions GPS ou des états de coupure en cours, et
dans lequel les valeurs caractéristiques sont, par exemple, des valeurs caractéristiques électriques, comme le courant, la tension et des grandeurs qui peuvent s'en déduire.
- de manière à simuler le fonctionnement du dispositif (15) d'alimentation en électricité, au moins à l'aide du modèle et de la au moins une grandeur (KG1) caractéristique,
- et ensuite on compare, dans une plage (12) en cours, la au moins une valeur (KG3, KG4) caractéristique calculée à la au moins une valeur (KG2) caractéristique déterminée en cours,
- et ensuite on calcule à l'avance au moins une valeur (KG5) caractéristique à venir à l'aide de la simulation au moins dans un laps de temps d'avenir souhaité et on compare la au moins une valeur (KG5) caractéristique à venir calculée à l'avance à au moins une valeur (11) limite donnée à l'avance dans une plage (13) de prévision et
- sur la base des résultats de la comparaison, dans la plage (12) en cours et dans la plage (13) de prévision, on calcule, à l'aide de la simulation, des prescriptions pour le fonctionnement à venir de l'installation (1) de la technique des transports et, si l'on atteint et/ou si l'on dépasse la au moins une valeur (11) limite, on émet automatiquement au moins un message (18) d'alerte et/ou on lance automatiquement au moins une mesure influençant par exemple la manière de circuler des trains par une commande automatique de train.

2. Procédé suivant la revendication 1,
**caractérisé en ce que**
l'on détermine en temps réel la au moins une valeur (KG2) caractéristique en cours.

3. Procédé suivant la revendication 1 ou 2,
**caractérisé en ce que**
l'on détermine en temps réel la au moins une grandeur (KG1) caractéristique en cours.

4. Dispositif (9) de contrôle d'un dispositif (15) d'alimentation en électricité d'une installation (1) de la technique des transports, comprenant au moins un dispositif (5) de modélisation, qui est constitué pour établir, à partir de paramètres pertinents définis à l'avance pour le dispositif (15) d'alimentation en électricité, un modèle reposant sur l'informatique du dispositif (15) d'alimentation en électricité,
**caractérisé par**
- au moins un dispositif (8) de relevé, qui est constitué pour déterminer en fonctionnement continu au moins une grandeur (KG1) caractéristique en cours et au moins une valeur (KG2) caractéristique en cours de l'installation (1) de la technique des transports,
- au moins un dispositif (6) de simulation, qui est constitué pour la simulation du dispositif (15) d'alimentation en électricité à l'aide du modèle et de la au moins une grandeur (KG1) caractéristique, pour le calcul d'au moins une valeur (KG3, KG4) caractéristique et pour le calcul à l'avance d'au moins une valeur (KG5) caractéristique à venir, au moins un laps de temps à venir souhaité,
- une plage (12) en cours, dans laquelle on compare la au moins une valeur (KG3, KG4) caractéristique calculée à la au moins une valeur (KG2) caractéristique déterminée en cours et
- une plage (13) de prévision, dans laquelle on compare la au moins une valeur (KG5) caractéristique à venir calculée à l'avance à au moins une valeur (11) limite donnée à l'avance, et
- une unité (17) de calcul, qui est constituée pour calculer sur la base des résultats de la comparaison, à l'aide de la simulation, des prescriptions pour le fonctionnement à venir de l'installation (1) de la technique des transports et pour émettre automatiquement, si la au moins une valeur (11) limite est atteinte et/ou dépassée, au moins un message (18) d'alerte et/ou pour lancer automatiquement au moins une mesure.

5. Installation (1) de la technique des transports, **caractérisée en ce que**
l'installation comprend un dispositif (9) suivant la revendication 4.
